# EUROPEAN PATENT APPLICATION

(11) **EP 3 460 865 A1**
(43) Date of publication of application: **27.03.2019**
(21) Application number: 17755042.3
(22) Date of filing: 16.02.2017
(51) Int. Cl.: H01L 51/56, C23C 14/04

(54) **COUNTERFORCE APPLYING APPARATUS, MASK MANUFACTURING APPARATUS, AND CORRESPONDING METHOD**

(30) Priority: 19.05.2016 CN 201610332615
(71) Applicant: BOE Technology Group Co., Ltd., Beijing 100015 (CN); Ordos Yuansheng Optoelectronics Co., Ltd., Ordos, Inner Mongolia 017020 (CN)
(72) Inventor: LIN, Zhiming, Beijing 100176 (CN); WANG, Zhen, Beijing 100176 (CN); HUANG, Chun Chieh, Beijing 100176 (CN); ZHANG, Jian, Beijing 100176 (CN)
(74) Representative: Jacobacci Coralis Harle
(86) International application number: PCT/CN2017/073804
(87) International publication number: WO 2017/197937

(57) **Abstract**

The invention discloses a counterforce apparatus, mask manufacturing apparatus and corresponding method, the force applying apparatus includes one or more applying apparatus body; one or a plurality of contact members, and each application apparatus is connected with the main body of the pivot, the contact member is configured to contact with the frame, applying apparatus body is configured for the contact member and applied against force to the frame by means of the contact member is driven by the mobile, wherein the contact component rotation freedom is restricted.

## Description

### CROSS REFERENCE TO RELATED APPLICATIONS

This application claims the benefit and priority of the Chinese patent application No. 201610332615.3 filed on May 19, 2016, and the full text of the above patent application is incorporated herein by reference as part of this application.

### TECHNICAL FIELD

Embodiments of the present disclosure relates to the field of display panel manufacturing, more specifically, to a counterforce applying apparatus, a mask manufacturing apparatus, and corresponding methods.

### BACKGROUND

The fine metal mask (FMM) mode of organic light emitting diode (OLED) panel manufacturing is an approach where OLED materials are evaporated onto a low-temperature poly-silicon (LTPS) backplate according to a predetermined program through an evaporation method, in which patterns on the FMM are utilized to evaporate red, green and blue organic materials to predetermined positions. For this reason, it is necessary to make the FMM first.

When making FMM, first a frame needs to be prepared, then a counterforce (CF) is applied to the frame through a counterforce applying apparatus, in order to make the frame to have a pre-deformation, and finally a FMM sheet is soldered on the frame. Through the pre-deformation of the frame, the FMM sheet can be expanded outwards during use, resulting in a stretching effect on the mask that counter balances the shrinking tendency of the mask itself, so as to maintain the tension and the shape stability of the mask.

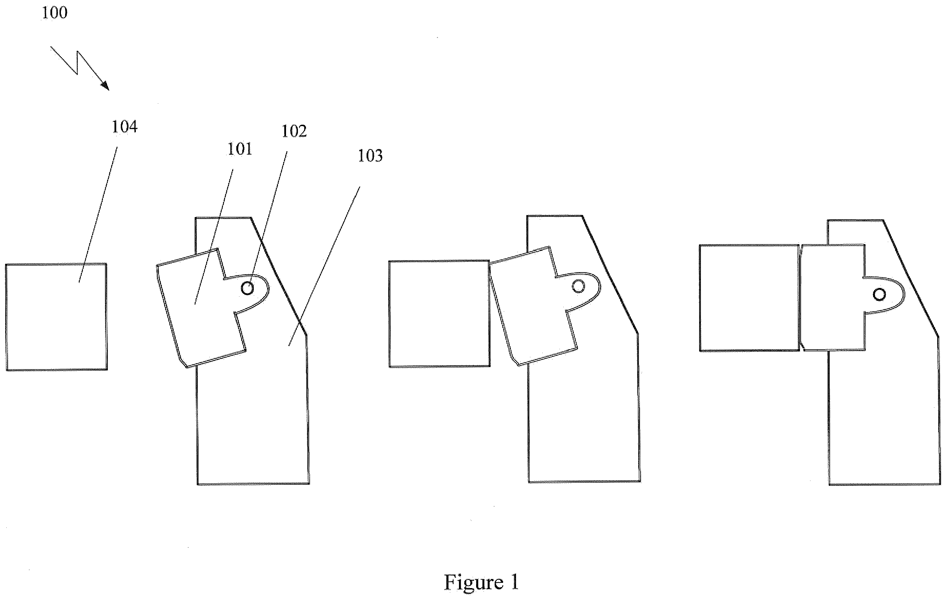

Figure 1 shows a schematic diagram of a counterforce applying apparatus that exerts a counterforce to a FMM frame. As shown in Figure 1, the counterforce applying apparatus 100 includes a contact member 101, the contact member 101 connecting with an applying apparatus body 103 through a pivot 102 (as known in the field, a connection through a pivot may be called a pivot connection), therefore, the contact member 101 has a rotation freedom and can deflect counterclockwise under the gravity. In the process of the counterforce applying apparatus 100 contacting the frame 104, the upper corner of the contact member 101 first contact the contact surface of the frame 104, and under the action of a push force, the contact member 101 is rotated clockwise by hindrance of the contact surface of the frame 104, until a state is reached where the contact surface of the contact member 101 and the contact surface of the frame 104 is in full contact, so as to achieve a processing effect of producing a necessary pre-deformation in frame 104 through applying a sufficient counterforce to the frame 104 by the counterforce applying apparatus 100. The setting of the contact member 101 enables the complete contact of the contact surface of the frame 104 with the contact member 101 even when the contact surface of the frame 104 is not completely vertical.

However, since the contact member 101 have a great freedom of movement, sometimes when the contact member 101 and the frame 104 come into contact, the frame 104 only comes into contact with a corner of the contact member 101, resulting in that the contact member 101 cannot contact the frame completely, causing an uneven application of force, thereby affecting the stability of the frame product 104, and make the frame product deformed.

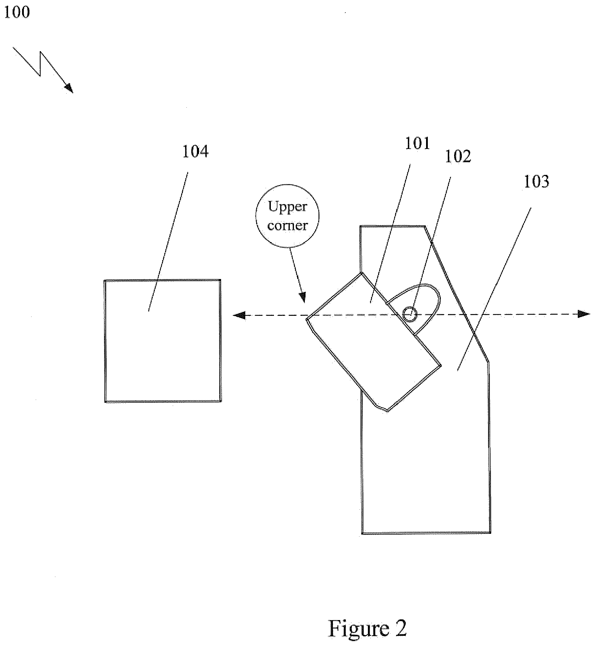

Figure 2 illustrates such an anomaly. As shown in Figure 2, the pivot 102 connecting the contact member 101 and the applying apparatus body 103 is usually a round shaft with 360 degrees of freedom, and the contact member 101 is front loaded, so the contact member 101 is prone to deflect downwards with a large degree of freedom. When the upper corner of the contact member 101 is lower than the horizontal line of the pivot 102, in the process of the contact member 101 coming into contact with the frame, the contact member cannot achieve a good contact state with the frame under the action of the push force, resulting in an anomaly state.

It can be seen that an improved counterforce applying apparatus and its contact member are needed in the field.

### SUMMARY

In one aspect of the disclosure, there is provided a counterforce applying apparatus, comprising: one or more applying apparatus bodies; one or more contact members each pivotally connected to an applying apparatus body, wherein the contact member is configured for contacting with the frame, the applying apparatus body is configured for moving the contact member by movement and applying a counterforce to the frame by means of the contact member, wherein the rotation freedom of the contact member is restricted.

In another aspect of the present disclosure, there is provided a mask manufacturing apparatus, comprising a counterforce applying apparatus according to any embodiment of the present disclosure.

In another aspect of the disclosure, there is provided a counterforce applying method, comprising: restricting a rotation freedom around a pivot of a contact member of a counterforce applying apparatus; making the contact member to contact with a frame; and applying a counterforce to the frame by the counterforce applying apparatus by means of the contact member.

In another aspect of the disclosure, there is provided a mask manufacturing method, comprising: preparing a frame; applying a counterforce to the frame by using a counterforce applying method according to an embodiment of the present disclosure so as to make the frame pre-deformed; soldering a mask sheet to the frame.

In another aspect of the disclosure, there is provided a method for manufacturing an OLED panel, comprising: manufacturing a mask by using a mask manufacturing method according to an embodiment of the present disclosure; and using the mask to evaporate OLED materials onto a backplate.

According to embodiments of the disclosure, by restricting the rotation freedom of a contact member, the shortcoming of being prone to produce bad contact between the contact member and the frame is overcome; at the same time, because part of the rotation freedom of the contact member is still retained, this does not affect the contact member to play its normal functions, ensuring the integrity of contact between the contact member and the frame.

### BRIEF DESCRIPTION OF DRAWINGS

Figure 1 shows a schematic diagram of a process in which a counterforce applying apparatus exerts a counterforce to a FMM frame;
Figure 2 illustrates an anomaly produced by an existing counterforce applying apparatus;
Figure 3 illustrates a counterforce applying apparatus according to an embodiment of the present disclosure;
Figure 4 illustrates a counterforce applying apparatus according to a first class of embodiments of the present disclosure;
Figure 5 illustrates a counterforce applying apparatus according to a second class of embodiments of the present disclosure;
Figure 6 illustrates a counterforce applying apparatus according to a third class of embodiments of the present disclosure;
Figure 7 illustrates a counterforce applying method according to an embodiment of the present disclosure;
Figure 8 illustrates a mask manufacturing method according to an embodiment of the present disclosure; and
Figure 9 illustrates a method for manufacturing an OLED panel according to an embodiment of the present disclosure.

### DETAILED DESCRIPTON OF SPECIFIC EMBODIMENTS

In order to make technicians in field to better understand the solution of the disclosure, the counterforce applying apparatus, mask manufacturing apparatus and corresponding method provided by embodiments of the disclosure will be described in further detail with reference to the drawings and specific implementations. Obviously, the embodiments described are some embodiments of the present disclosure, not all embodiments thereof. Based on the embodiments described of the present disclosure, all other embodiments obtained by ordinary technical personnel in the field without the need for creative labor are within the scope of protection of this disclosure.

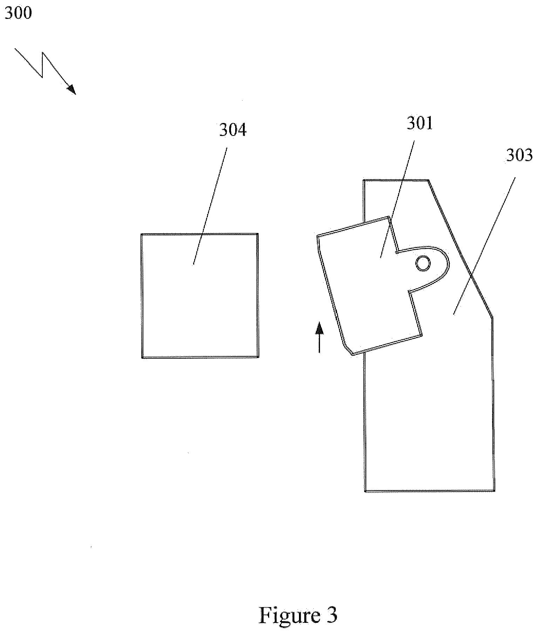

Referring to Figure 3, a counterforce applying apparatus 300 according to an embodiment of the present disclosure is shown. As shown in Figure 3, the counterforce applying apparatus 300 comprises: an applying apparatus body 303; and a contact member 301 pivotally connected to the applying apparatus body 303, wherein the contact member 301 is configured for contacting with the frame 304, the applying apparatus body 303 is configured for moving the contact member 301 by movement and applying a counterforce to the frame 304 through the contact member 301, wherein the rotation freedom of the contact member 301 is restricted.

Optionally, the applying apparatus body 303 may comprise a left and right applying apparatus bodies 303, and each of the applying apparatus bodies 303 is pivotally connected with a contact member 301. Thus, the two applying apparatus bodies 303 can be moved from both sides of the frame 304 to the middle, which drives the two contact members 301 to apply a counterforce to the frame 304, so as to produce a necessary pre-deformation in the frame 304. Alternatively, the applying apparatus body 303 can also be only one, and in this case, the frame 304 can be abutted on a blocking device, and the applying apparatus body 303 can be moved to the blocking device, driving the contact member 301 to apply a counterforce to the frame 304.

The number of contact members 301 pivotally connected with an applying apparatus body 303 can be either one or more, such as two or three. When a plurality of contact members 301 are provided on the applying apparatus body 303, it can be realized that counterforces are applied to the frame 304 at a plurality of positions (e.g., a plurality of vertical positions on the side of the frame 304) of the frame. Thus, a more uniform application of counterforce to the frame may be realized, thereby ensuring that necessary pre-deformations are produced more uniformly at a plurality of locations of the frame.

The frame 304 can be any component that requires pre-deformation, such as a frame for making a mask, which may be, for example, a FMM mask that can be used to produce an OLED panel.

In an embodiment of the disclosure, the rotation freedom of the contact member 301 is restricted, which means that the contact member 301 cannot be rotated by a large angle, for example, it cannot be rotated under its gravity to the extent that its upper corner is lower than the horizontal line of its pivot, but still retains certain rotation freedom. In this way, the shortcoming of being prone to produce bad contact between the contact member and the frame in the prior art is overcome; at the same time, this does not affect the contact member to play its normal functions, so as to ensure the integrity of contact between the contact member and the frame.

The present disclosure may restrict the rotation freedom of the contact member 301 in any appropriate manner. Several different methods for restricting the rotation freedom of the contact member 301 according to several different embodiments of the present disclosure are described below.

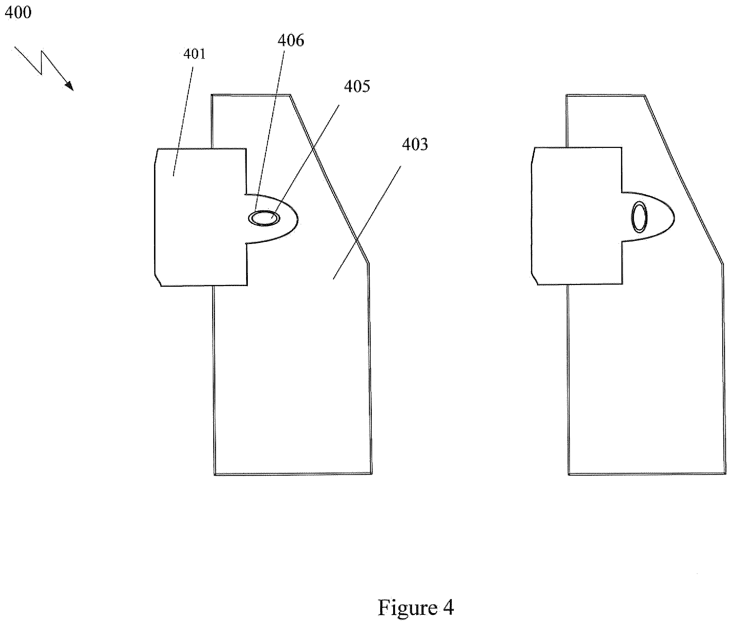

Referring to Figure 4, a counterforce applying apparatus 400 according to the first class of embodiments of the present disclosure is shown. As shown in Figure 4, the pivot 405 and the pivot hole 406 for the pivot connection are elliptical cylindrical.

In such embodiments of the present disclosure, utilizing the difference between the rotation freedom of an elliptical cylinder and that of a round cylinder, the pivot 405 and the pivot hole 406 are both configured to be in an elliptical cylindrical shape. The long axis of the elliptical cross section of the pivot 405 and that of the pivot hole 406 may be arranged horizontally or vertically. Since the elliptical cylindrical pivot 405 and the elliptical cylindrical pivot hole 406 have certain limitations in relative motion, the rotation angle of the contact member 401 is guaranteed not to be large. Thus, when in contact with the frame (not shown in Figure 4), a bad contact state between a corner of the contact member 401 and the frame may be avoided, while at the same time good contact may be maintained.

As technicians in the field can see, the pivot 405 can be provided on the contact member 401, and accordingly, the pivot hole 406 may be provided on the applying apparatus body 403. Alternatively, the pivot 405 may be provided on the applying apparatus body 403, and accordingly, the pivot hole 406 may be provided on the contact member 401. As another alternative, pivot holes 406 may be provided on the contact member 401 and applying apparatus body 403 respectively, accordingly, a separate 405 pivot may be installed in the pivot holes 406 on the contact member 401 and applying apparatus body 403.

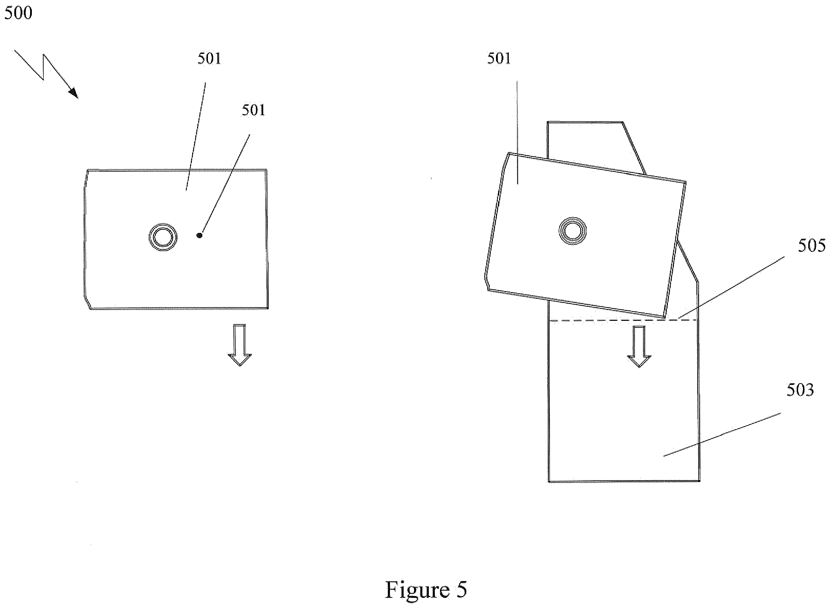

Referring to Figure 5, a counterforce applying apparatus 500 according to the second class of embodiments of the present disclosure is shown. In such embodiments of the present disclosure, the degree of freedom is restricted by a combination of the weight distribution of the contact member 501 and the support of a platform 505 of the counterforce applying apparatus 500. As shown in Figure 5, the distance from the center 502 of gravity of the contact member 501 to the contact surface 504 of the contact member 501 is greater than the distance from the center 506 of rotation (i.e. pivot center) of the contact member 501 to contact surface 504 of the contact member 501. That is to say, the weight of the portion of the contact member 501 located on the inside of the pivot (i.e., the side facing the internal of the counterforce applying apparatus) is greater, so that this portion of the contact member 501 has a downward tendency. In addition, the applying apparatus body 503 is provided with a support platform 505 thereon, the platform 505 functioning to restrict the natural droop of the contact member 501, thereby preventing the contact member 501 to rotate to a too large angle, resulting in the state where only a upper corner of the contact member 501 is in contact with the frame, so as to ensure good contact between the contact member 501 and the frame in the process of force application 501.

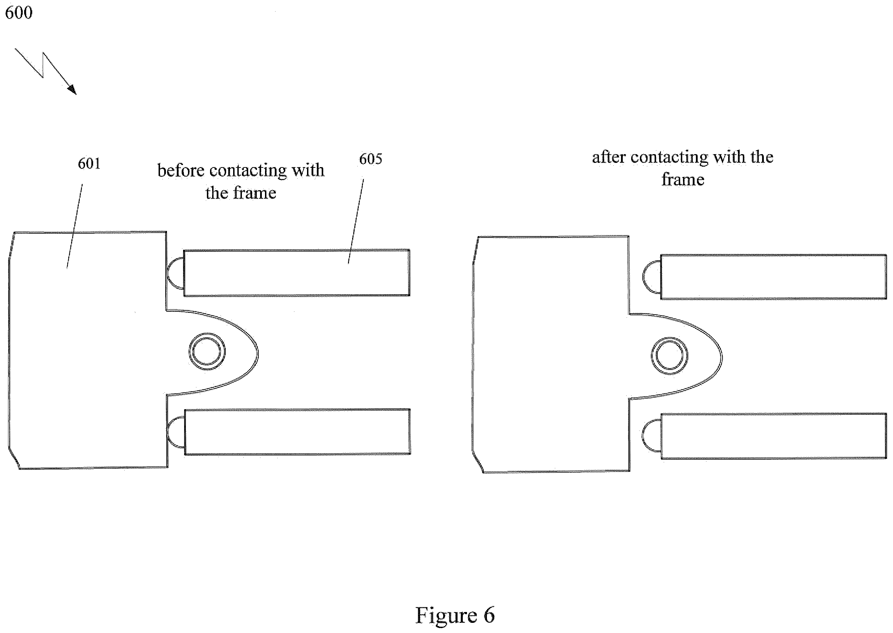

Referring to Figure 6, a counterforce applying apparatus 600 according to a third class of embodiments of the present disclosure is shown. As shown in Figure 6, the counterforce applying apparatus 600 further comprises a mechanical support rod 605 for restricting the rotation freedom of the contact member 601.

In such embodiments of the present disclosure, the rotation of the contact member 601 is restricted by the mechanical support rod 605, and this restriction is loose and should ensure a certain degree of rotation freedom of the contact member 601.

Optionally, the mechanical support rod 605 may comprise two mechanical support rods, for supporting at an upper and lower positions on the inner surface 608 (that is, the surface opposite to the contact surface 604) of the contact member 601 respectively; or, the mechanical support rod 605 may comprise one mechanical support rod for supporting at a lower position on the inner surface 608 of the contact member 601. The upper position is any position on the inner surface 608 of the contact member 601 above the horizontal line of the center of rotation 606 of the contact member 601 when the contact surface 604 of the contact member 601 is in the vertical state; the lower position is any position on the inner surface 608 of the contact member 601 below the horizontal line of the center of rotation 606 of the contact member 601 when the contact surface 604 of the contact member 601 is in the vertical state.

Optionally, the support rod 605 is movable, and the support rod 605 may be used for contacting with the contact member 601 and restricting the rotation freedom of the contact member 601 before the contact member 601 and the frame (not shown in Figure 6) come into contact with each other.

Further optionally, after the contact member 601 comes into contact with the frame, the support rod 605 is separated from the contact member 601. Alternatively, the support rod 605 may also be fixed.

While a counterforce applying apparatus according to embodiments of the present disclosure has been described above with reference to the drawings, it shall be noted that the above description is for example only, not for the limitations of the present disclosure. In other embodiments of the present disclosure, the counterforce applying apparatus may have more, less, or different components, and the relationships of inclusion, connection, and function etc. among the components may be different from those described and illustrated. For example, the counterforce applying apparatus may also comprise a mechanism for moving the applying apparatus body and applying a counterforce to the frame by means of the contact member, etc. For another example, the shapes, relative sizes, and positional relations of the applying apparatus body and the contact member shown in the drawings do not constitute a limitation to the present disclosure. Also, for example, the features included in the above exemplary embodiments may generally be combined in a variety of ways known to a technical person in the field, thereby forming new embodiments.

In another aspect of the disclosure, a mask manufacturing apparatus is provided that comprises the above-mentioned counterforce applying apparatus according to any embodiment of the present disclosure. The mask manufacturing apparatus, for example, may be used to make an FMM mask, and the FMM mask, for example, may be used to manufacture OLED panels. Of course, the mask manufacturing apparatus may also be used to manufacture other masks. As a technical person in the field can know, the mask manufacturing apparatus may also include other components, which may be any appropriate components existing in the field or to be developed in the future, and which will not be described here repeatedly.

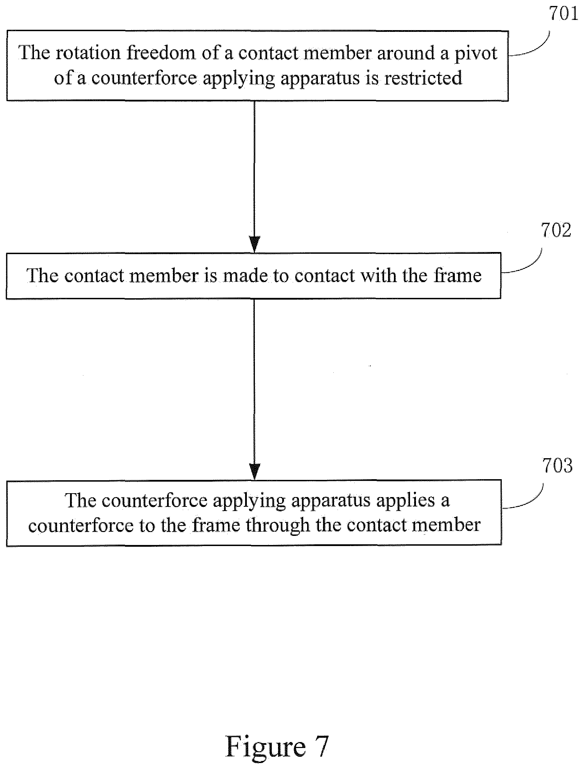

Referring to Figure 7, a counterforce applying method according to an embodiment of the present disclosure is shown. As shown in Figure 7, the method may comprise the following steps:
In step 701, the rotation freedom of a contact member around a pivot of a counterforce applying apparatus is restricted;
In step 702, the contact member is made to contact with the frame; and
In step 703, the counterforce applying apparatus applies a counterforce to the frame through the contact member.

For the specific manner of restricting the rotation freedom of a contact member around a pivot of a counterforce applying apparatus in step 701, reference may be made to the above description of the counterforce applying apparatus according to embodiments of the disclosure. For example, the rotation freedom of the contact member may be restricted by using an elliptical cylindrical pivot and pivot hole, by a combination of the weight distribution of the contact member and support of a platform, by using a mechanical support rod, etc., which will not be repeated here. The steps 702 and 703 may be implemented in any appropriate way existing as known to a technical person in the field or to be developed in the future, which will be not repeated here.

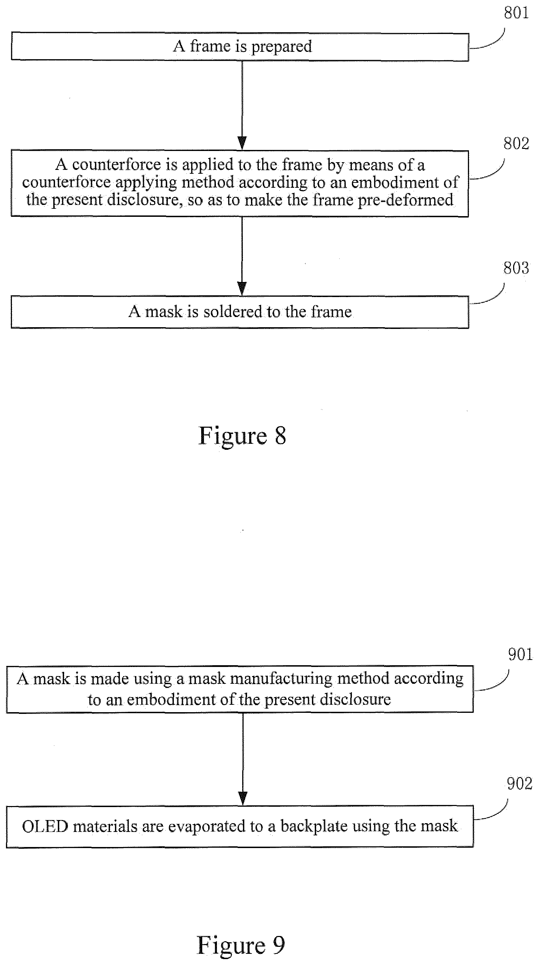

Referring to Figure 8, a mask manufacturing method according to an embodiment of the present disclosure is shown. As shown in Figure 8, the method comprises the following steps:
In step 801, a frame is prepared;
In step 802, a counterforce is applied to the frame by means of a counterforce applying method according to an embodiment of the present disclosure, so as to make the frame pre-deformed;
In step 803, a mask is soldered to the frame.

The steps 801 and 803 may be implemented in any appropriate manner existing as known to a technical person in the field or to be developed in the future, which will not be repeated here.

Referring to Figure 9, a method for manufacturing an OLED panel according to an embodiment of the present disclosure is shown. As shown in Figure 9, the method comprises the following steps:
In step 901, a mask is made using a mask manufacturing method according to an embodiment of the present disclosure; and
In step 902, OLED materials are evaporated to a backplate using the mask.

The steps 902 may be implemented in any appropriate way existing as known to a technical person in the field or to be developed in the future, which will not be repeated here.

While a counterforce applying method, a mask manufacturing method and an OLED panel manufacturing method according to embodiments of the disclosure have been described above with reference to the drawings, it should be noted that the above description is only for example, rather than limitation to the disclosure. In other embodiments of the present disclosure, the method may have more, less, or different steps, and the relationships of order, inclusion, function etc. among the steps may be different from those described and illustrated. For example, generally, multiple steps may also be considered as a larger step, and multiple sub-steps contained in a step may also be considered as separate steps. For another example, the order of the steps in the above description and illustration generally does not constitute a limitation on the methods of the disclosure, and the steps may be performed in any order or concurrently as may be known to a technical person in the field. For another example, the features contained in the above exemplary embodiments may generally be combined with each other in a variety of appropriate methods as known to a technical person in the field to form new embodiments.

Understandably, the above embodiments of the present disclosure are merely illustrative embodiments used to illustrate the principles of this disclosure, and this disclosure is not limited to this. For an ordinary technical person in the field, various kinds of change and improvement may be made without departing from the spirit and essence of the disclosure, and the change and improvement are also deemed to be within the scope of protection of the disclosure. The scope of protection of the present disclosure is limited only by the meanings expressed in the language of the appended claims and their equivalent meanings.

## Claims

1. A counterforce applying apparatus, comprising:
one or more applying apparatus bodies;
one or more contact members each pivotally connected to an applying apparatus body,
wherein the contact member is configured for contacting with a frame, the applying apparatus body is configured for moving the contact member by movement and applying a counterforce to the frame by means of the contact member, wherein the rotation freedom of the contact member is restricted.

2. The counterforce applying apparatus according to claim 1, wherein a pivot and pivot hole for the pivotal connection are elliptical cylindrical.

3. The counterforce applying apparatus according to claim 1, wherein the distance from the center of gravity of the contact member to the contact surface of the contact member is greater than the distance from the center of rotation of the contact member to the contact surface of the contact member, and on the applying apparatus body is provided a support platform for restricting the natural droop of the contact member.

4. The counterforce applying apparatus according to claim 1, further comprising a mechanical support rod for restricting the rotation freedom of the contact member.

5. The counterforce applying apparatus according to claim 4, wherein the mechanical support rod comprises two mechanical support rods for supporting at an upper position and a lower position on the inner surface of the contact member respectively; or comprises a mechanical support rod for supporting at a lower position on the inner surface of the contact member.

6. The counterforce applying apparatus according to claim 4, wherein the support rod is movable, and the support rod is used to contact the contact member and restrict the rotation freedom of the contact member before the contact member contacts with the frame.

7. The counterforce applying apparatus according to claim 6, wherein the support rod is separated from the contact member after the contact member is in contact with the frame.

8. The counterforce applying apparatus according to claim 4, wherein the support rod is fixed.

9. A mask manufacturing apparatus, comprising a counterforce applying apparatus according to any of claims 1-8.

10. A counterforce applying method, comprising:
restricting a rotation freedom around a pivot of a contact member of a counterforce applying apparatus;
making the contact member to contact with a frame; and
applying a counterforce to the frame by the counterforce applying apparatus by means of the contact member.

11. A mask manufacturing method, comprising:
preparing a frame;
applying a counterforce to the frame by using a method according to claim 10 so as to make the frame pre-deformed;
soldering a mask sheet to the frame.

12. A method for manufacturing an OLED panel, comprising:
manufacturing a mask by using a method according to claim 11; and
using the mask to evaporate OLED materials onto a backplate.
